Europäisches Patentamt

European Patent Office

Office européen des brevets

(19)

(11) Publication number: **0 106 953**
**B1**

(12) **EUROPEAN PATENT SPECIFICATION**

(45) Date of publication of patent specification: **11.03.87**

(51) Int. Cl.⁴: **H 03 F 1/30**

(21) Application number: **83107657.5**

(22) Date of filing: **03.08.83**

(54) Amplifier.

(30) Priority: **24.09.82 JP 164836/82**

(43) Date of publication of application:
**02.05.84 Bulletin 84/18**

(45) Publication of the grant of the patent:
**11.03.87 Bulletin 87/11**

(84) Designated Contracting States:
**DE FR GB IT**

(56) References cited:
**DE-A-2 357 597**
**GB-A-1 401 457**
**US-A-4 112 385**

**Patent Abstract of Japan Vol. 4, no. 21, 21
February 1980**

**Patent Abstracts of Japan Vol. 5, no. 66, 2 May
1981**

(73) Proprietor: **HITACHI, LTD.**
**6, Kanda Surugadai 4-chome Chiyoda-ku
Tokyo 100 (JP)**

(72) Inventor: **Seki, Kunio**
**2196-65, Hirai Hinode-cho
Nishitama-gun Tokyo (JP)**
Inventor: **Takeshita, Ritsuji**
**5577-38, Kuragano-cho
Takasaki-shi Gunma-ken (JP)**

(74) Representative: **Patentanwälte Beetz sen. -
Beetz jun. Timpe - Siegfried - Schmitt-Fumian
Steinsdorfstrasse 10
D-8000 München 22 (DE)**

## Description

### Background of the Invention

The present invention relates to an amplifier according to the preamble of claim 1.

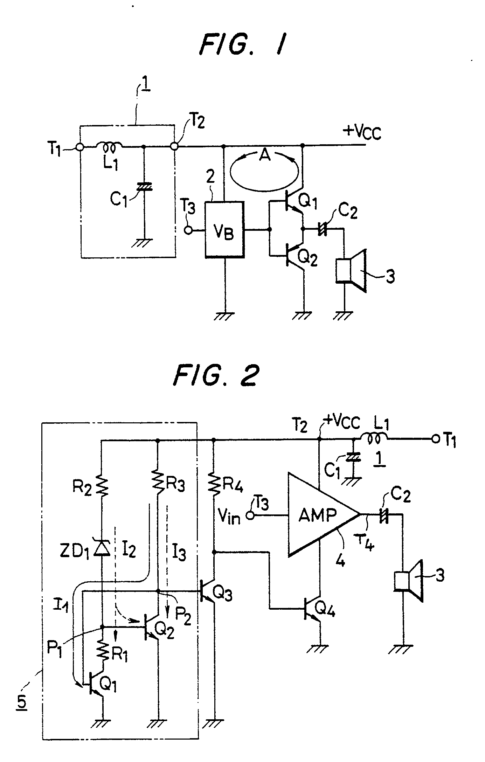

Prior to the invention of the present application an amplifier shown in Figure 1 was studied by the inventors. Figure 1 is a circuit diagram which schematically illustrates the amplifier.

The terminal $T_1$ of a smoothing circuit 1 is supposed to be supplied with a power source voltage from a rectifier circuit (not shown) or a car battery. This power source voltage is smoothed by a coil $L_1$ and a capacitor $C_1$, and the smoothed voltage is fed as a supply voltage $+V_{cc}$ from a terminal $T_2$ to an amplifier circuit. A bias circuit 2 supplies a bias voltage $V_B$ to output transistors $Q_1$ and $Q_2$.

When an input signal fed to an input terminal $T_3$ is positive-going, the output transistor $Q_1$ falls into its "on" state, and an output current flows from the $+V_{cc}$ power supply to a speaker 3 via this transistor $Q_1$ as well as a capacitor $C_2$. On the other hand, when the input signal of the input terminal $T_3$ is negative-going, the output transistor $Q_2$ falls into its "on" state, and the discharge current of the capacitor $C_2$ flows to the speaker 3 via this output transistor $Q_2$ as well as an earth line.

The inventors' study has revealed that, when the supply voltage $+V_{cc}$ rises gradually upon closure of the power source or the power source voltage has fluctuated drastically, the operation of the circuit becomes unstable to give rise to a phenomenon as described below.

First, regarding the time of the closure of the power source, before the $+V_{cc}$ power supply reaches an ordinary voltage level, the amplifier circuit comes into a oscillating condition at a certain voltage level, and noise develops. Further, when the power source voltage has drastically fluctuated to sharply lower the supply voltage $+V_{cc}$, the amplifier circuit comes into an oscillating condition and fails to perform the normal amplifying operation thereof, and noise as stated above develops.

The inventors studied the phenomenon still more. As a result, it has been revealed that, in case of using a commercial power source or even in case of using the car battery as the power source, the phenomenon is liable to occur particularly when the smoothing circuit 1 has an inductance component. When the power source voltage contains a ripple component or a noise component, the coil $L_1$ and the capacitor $C_1$ come into a parallel resonant condition, and the impedance of the smoothing circuit 1 becomes high. Then, a positive feedback loop as indicated by arrow A is formed between the output transistor $Q_1$ and the bias circuit 2. In the amplifier circuit, accordingly, a kind of blocking oscillating operation is conducted, due to which the phenomena described above take place.

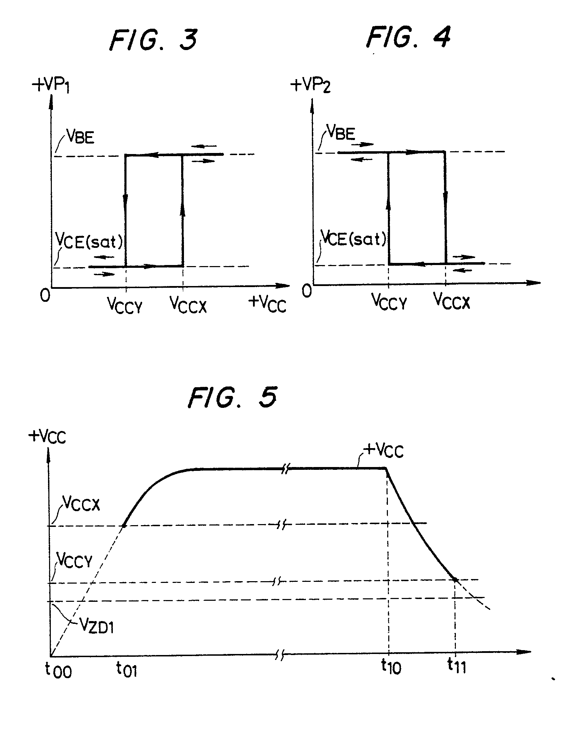

The JP—A—54 161 304 discloses an amplifier according to the preamble of claim 1. The supply voltage detector shown in Fig. 3 of the mentioned JP—A—54 161 304 detects fluctuations of the supply voltage and drives the switching circuit so that a bias circuit for the amplifier circuit is cut off. Furthermore, in Fig. 4 of the JP—A—54 161 304 is disclosed that the supply voltage detector has a single threshold level which is determined by Zener voltages of Zener diodes and a base emitter voltage of transistor 34. However, there is disclosed no hysterisis characteristics for detecting magnitudes of the supply voltage. Thus, the amplifying operation of the amplifier circuit in JP—A—54 161 304 is frequently started and stopped when the level of the supply voltage repeatedly rises and falls with the boundary of the single threshold level so that the operation of the amplifier circuit might disadvantageously become unstable.

### Summary of the Invention

It is therefor an object of the present invention to provide an amplifier which can stably operate during a transient period before a power source voltage is stabilized upon closure of a power source.

The above object is solved in an amplifier according to the preamble of claim 1 by the characterizing features of claims 1 according to the invention.

The subclaims 2 to 5 characterize advantageous developments thereof.

The invention is explained in detail in connection with the following drawings:

Figure 1 is a circuit diagram of an amplifier which was studied by the inventors of the present application prior to the present invention;

Figure 2 is a circuit diagram of an amplifier embodying the present invention;

Figures 3 and 4 are characteristic diagrams illustrative of the voltage variations of respective circuit nodes $P_1$ and $P_2$ in the circuit of Figure 2 corresponding to the rise and fall of a power source voltage;

Figure 5 is a waveform diagram illustrative of the rise and fall of a supply voltage $+V_{cc}$;

Figure 6 is a circuit diagram of an amplifier circuit according to a more preferable embodiment of the present invention; and

Figure 7 shows a circuit diagram in the case where the present invention is not applied.

### Description of the Preferred Embodiments

Referring now to the drawings, the embodiments of the present invention will be concretely described. Figure 2 shows a circuit diagram of an amplifier according to one embodiment of the present invention. A terminal $T_1$ is connected to a power source (not shown) such as car battery, and is also connected to a smoothing circuit 1 which consists of a coil $L_1$ and a capacitor $C_1$.

Thus, a smoothed supply voltage $+V_{cc}$ is derived from the output terminal $T_2$ of the smoothing circuit 1. This supply voltage $+V_{cc}$ is fed to an amplifier circuit 4 as the operating voltage thereof. The input terminal $T_3$ of the

amplifier circuit 4 is supplied with an input signal voltage $V_{in}$. An output signal derived from the output terminal $T_4$ of the amplifier circuit 4 is fed to a speaker load 3 through an output coupling capacitor $C_2$.

According to the present invention, a supply voltage detector 5 is especially arranged in this amplifier. this supply voltage detector 5 possesses a hysteresis characteristic in its detecting operation. The amplifying operation of the amplifier circuit 4 is controlled into the operating condition or non-operating condition thereof by the output signal of the supply voltage detector 5.

In the embodiment of Figure 2, the supply voltage detector 5 is constructed of transistors $Q_1$, $Q_2$, a Zenar diode $ZD_1$ and resistors $R_1$, $R_2$, $R_3$ as shown in the figure. Further, the output signal of the supply voltage detector 5 controls the operation of the amplifier circuit 4 through other control transistors $Q_3$, $Q_4$.

Now, as shown in Figure 5, when the power source is connected to the terminal $T_1$ at a time $t_{00}$, the supply voltage $+V_{cc}$ of the output terminal $T_2$ rises gradually.

In the period in which this supply voltage $+V_{cc}$ is lower than the Zener voltage $V_{ZD1}$ of the Zener diode $ZD_1$, the current $I_2$ of a series path consisting of the resistor $R_2$ and the Zener diode $ZD_1$ is null, so that the transistor $Q_2$ is "off", and also the current $I_3$ of the collector-emitter path of this transistor is null. On the other hand, when the supply voltage $+V_{cc}$ has become greater than the base-emitter voltage $V_{BEQ1}$ of the transistor $Q_1$, current $I_1$ begins to flow through a series path consisting of the resistor $R_3$ and the base-emitter junction of the transistor $Q_1$. In contrast, the collector of the transistor $Q_1$ is not supplied with any current from the series path consisting of the resistor $R_2$ and the Zener diode $ZD_1$, so that the transistor $Q_1$ is driven into its saturation region. Thus, the collector-emitter voltage of the transistor $Q_1$ is held at a very small saturation voltage $V_{CE(sat)Q1}$. In this state, accordingly, the voltage $V_{P1}$ of a node $P_1$ becomes $V_{CE(sat)Q1}$, and the voltage $V_{P2}$ of a node $P_2$ becomes $V_{BEQ1}$.

When the supply voltage $+V_{cc}$ has become higher than the Zener voltage $V_{ZD1}$ of the Zener diode $ZD_1$, the current $I_2$ begins to flow through a series path consisting of the resistor $R_2$, Zener diode $ZD_1$ and resistor $R_1$. Accordingly, the potential of the node $P_1$ rises owing to a voltage drop $R_1.I_2$ across the resistor $R_1$. with the collector-emitter saturation voltage $V_{CE(sat)Q1}$ of the transistor $Q_1$ neglected because of being very small, the requirement under which the transistor $Q_2$ turns from the "off" state into the "on" state will be calculated below:

$$V_{cc} = R_2.I_2 + V_{ZD1} + V_{BEQ2} \qquad (1)$$

$$R_1.I_2 > V_{BEQ2} \qquad (2)$$

From equation (1),

$$I_2 = \frac{V_{cc} - V_{ZD1} - {}_{BEQ2}}{R_2} \qquad (3)$$

Substituting Equation (3) into Inequality (2),

$$\frac{R_1}{R_2}(V_{cc} - V_{ZD1} - V_{BEQ2}) > V_{BEQ2}$$

$$V_{cc} - V_{ZD1} - V_{BEQ2} > \frac{R_2}{R_1} V_{BEQ2}$$

$$V_{cc} > V_{ccx} = V_{ZD1} + \frac{R_1 + R_2}{R_1}.V_{BEQ2} \qquad (4)$$

Accordingly, when the supply voltage $+V_{cc}$ has become higher than $V_{ccx}$ as indicated in Expression (4), the transistor $Q_2$ turns from the "off" state into the "on" state, and the transistor $Q_1$ turns from the "on" state into the "off" state. Accordingly, the voltage $V_{P2}$ of the node $P_2$ changes from $V_{BEQ1}$ into $V_{CE(sat)Q2}$, and the voltage $V_{P1}$ of the node $P_1$ changes from $V_{CE(sat)Q1}$ into $V_{BEQ2}$.

Further, as shown in Figure 5, when the power source is disconnected from the terminal $T_1$ at a time $t_{10}$, the supply voltage $+V_{cc}$ of the output terminal $T_2$ lowers gradually. In the range in which the supply voltage $+V_{cc}$ is comparatively high to allow the current $I_2$ to flow through the Zener diode $ZD_1$, the transistor $Q_2$ is in the "on" state, and the transistor $Q_1$ is in the "off" state.

In addition, the requirement under which the lowering of the supply voltage $+V_{cc}$ results in turning the transistor $Q_2$ from the "on" state into the "off" state and turning the transistor $Q_1$ from the "off" state into the "on" state is as mentioned below:

$$V_{cc} < V_{ccY} = V_{ZD1} + V_{BEQ2} \qquad (5)$$

Accordingly, when the supply voltage $+V_{cc}$ has become lower than $V_{ccY}$ as indicated in Expression (5), the transistor $Q_2$ turns from the "on" state into the "off" state, and the transistor $Q_1$ is driven from the "off" state into the saturation region. Accordingly, the voltage $V_{P2}$ of the node $P_2$ changes from $V_{CE(sat)Q2}$ into $V_{BEQ1}$, and the voltage $V_{P1}$ of the node $P_1$ changes from $V_{BEQ2}$ into $V_{CE(sat)Q1}$.

The varying hysteresis characteristics of the voltage $V_{P1}$ of the node $P_1$ and the voltage $V_{P2}$ of the node $P_2$, which correspond to the rise and fall of the supply voltage $+V_{cc}$ as described above, are respectively shown in Figure 3 and Figure 4.

Thus, after the power source has been connected to the terminal $T_1$ at the time $t_{00}$, the transistor $Q_2$ turns from the "off" state into the "on" state at a time $t_{01}$ at which $V_{cc} < V_{ccx}$ is established. Accordingly, another control transistor $Q_3$ turns from the "on" state into the "off" state. Then, the transistor $Q_4$ connected thereto turns from the "off" state into the "on" state, and it begins to supply the bias to the amplifier circuit 4. In this way, the amplifier circuit 4 starts the amplifying operation for the input signal voltage $V_{in}$ since the time $t_{01}$.

Meanwhile, after the power source has been disconnected from the terminal $T_1$ at the time $t_{10}$, the transistor $Q_2$ turns from the "on" state into the "off" state at a time $t_{11}$ at which $V_{CC} < V_{CCY}$ is established. Thus, the amplifier circuit 4 stops the amplifying operation for the input signal voltage $V_{in}$ since the time $t_{11}$.

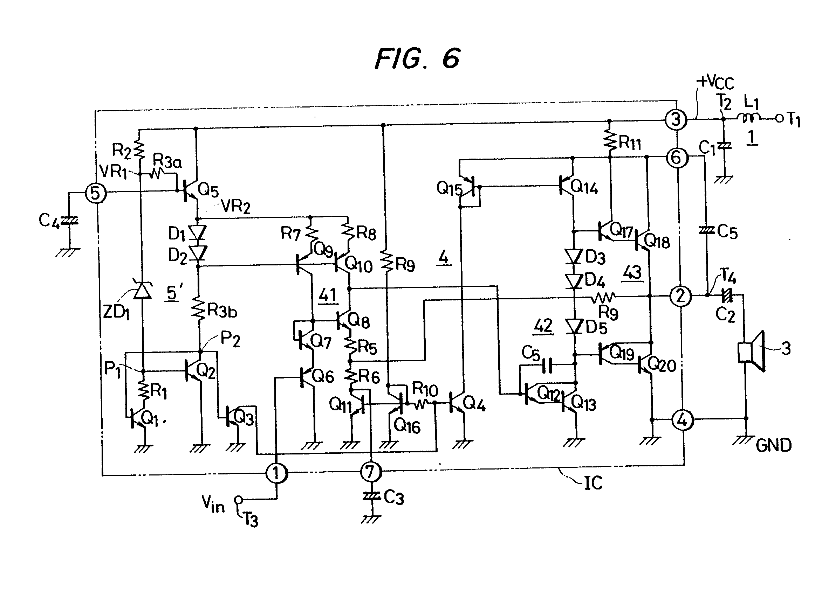

Figure 6 shows a circit diagram of an amplifier according to the more preferable embodiment of the present invention. Parts assigned the same symbols as in Figure 2 will not be described in detail, and different points will be especially explained below.

Circuit components inside a broken line IC are formed within a monolithic semiconductor integrated circuit (hereinbelow, termed "IC"), and numerals enclosed with circles denote the terminal numbers of the IC.

The points of difference of a supply voltage detector 5' in Figure 6 from the supply voltage detector 5 in Figure 2 are that the resistor $R_3$ in Figure 2 is replaced with a transistor $Q_5$, diodes $D_1$, $D_2$ and resistors $R_{3a}$, $R_{3b}$ in Figure 6, and that the Zener voltage $V_{ZD1}$ of the Zener diode $ZD_1$ contributes also to stabilizing the direct current of the amplifier circuit 4.

In the steady state in which the supply voltage $+V_{CC}$ is sufficiently greater than the Zener voltage $V_{ZD1}$ of the Zener diode $ZD_1$, the following reference voltage $V_{R1}$ is generated at the common node between the resistor $R_2$ and the Zener diode $ZD_1$:

$$V_{R1} = V_{ZD1} + V_{BEQ2} \qquad (6)$$

A capacitor $C_4$ and the resistor $R_{3a}$ which are connected to terminal No. 5 constitute a ripple filter. This ripple filter supplies the base of the emitter-follower transistor $Q_5$ with a D.C. voltage component in which a ripple component contained in the reference voltage $V_{R1}$ is attenuated. Accordingly, the following reference voltage $V_{R2}$ is derived from the emitter of the emitter-follower transistor $Q_5$:

$$V_{R2} = V_{R1} - V_{BEQ5} \doteqdot V_{ZD1} \qquad (7)$$

Such reference voltage $V_{R2}$ is utilized as the stabilized operating voltage of the initial-stage amplifier circuit 41 of the amplifier circuit 4. The initial-stage amplifier circuit 41 is composed of transistors $Q_6$, ....., $Q_{11}$ and resistors $R_5$, ....., $R_8$. The input signal voltage $V_{in}$ of the input terminal $T_3$ is transmitted to the base of the initial-stage amplifying transistor $Q_8$ through terminal No. 1, the emitter-follower transistor $Q_6$ and the level shift diode $Q_7$.

Some fluctuation in the supply voltage $+V_{CC}$ results in somewhat fluctuating a direct current which flows through the collector-emitter path of the transistor $Q_5$ of the supply voltage detector 5', the diodes $D_1$, $D_2$, the resistor $R_{3b}$, and the collector-emitter path of the transistor $Q_2$. Since, however, the forward voltages of the diodes $D_1$, $D_2$ are scarcely changed even by such some fluctuation of the direct current, currents to flow through the collector-emitter paths of the transistors $Q_9$, $Q_{10}$ are substantially stabilized.

Accordingly, the transistor $Q_9$ supplies the stabilized biasing direct current to the diode $Q_7$ as well as the emitter-follower transistor $Q_6$, while the transistor $Q_{10}$ operates as the constant current load of the initial-stage amplifying transistor $Q_8$. An amplified signal derived from the collector of the initial-stage amplifying transistor $Q_8$ is fed to the Darlington-connected transistors $Q_{12}$, $Q_{13}$ of a driving amplifier circuit 42. The Darlington-connected transistors $Q_{12}$, $Q_{13}$ have a phase compensation capacitor $C_5$ connected thereto, and are also connected to diodes $D_3$, $D_4$, $D_5$ functioning as bias means for reducing a crossover distortion. The collectors of the Darlington-connected transistors $Q_{12}$, $Q_{13}$ are connected to a constant current load transistor $Q_{14}$ through the diodes $D_3$, $D_4$, $D_5$.

A constant current to flow through this constant current load $Q_{14}$ is set by direct currents which flow through the collector-emitter paths of transistors $Q_{15}$, $Q_4$. In turn, the direct current to flow through the collector-emitter path of the transistor $Q_4$ is set by a direct current which flows through a resistor $R_9$ and the collector-emitter path of a transistor $Q_{16}$.

Further, a direct current which flows through the resistor $R_6$ and the collector-emitter path of the transistor $Q_{11}$ in the initial-stage amplifier circuit 41 is set by a direct current which flows through the collector-emitter path of the transistor $Q_{16}$.

A push-pull output circuit 43 which is composed of transistors $Q_{17}$, $Q_{18}$, $Q_{19}$, $Q_{20}$ is driven by the output signal of the driving amplifier circuit 42. Meanwhile, a negative feedback resistor $R_9$ is connected between terminal No. 2 (the output terminal of the amplifier circuit 4) and the common node of the resistors $R_5$, $R_6$, and a negative feedback capacitor $C_3$ is connected to terminal No. 7. A bootstrap capacitor $C_5$ connected between terminals No. 2 and No. 6 raises the voltage of terminal No. 6 to be higher in level than the supply voltage $+V_{CC}$.

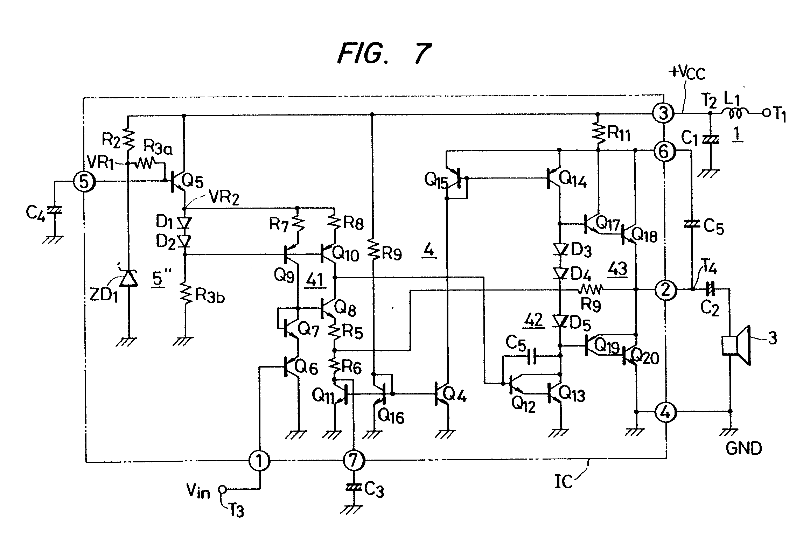

On the other hand, a circuit diagram of an amplifier in the case where the present invention is not applied is shown in Figure 7, and the transistors $Q_1$, $Q_2$, $Q_3$ and resistors $R_1$, $R_{10}$ are not included. In the circuit of Figure 7, a circuit 5'' which is composed of the Zener diode $ZD_1$, transistor $Q_5$, diodes $D_1$, $D_2$, resistors $R_2$, $R_{3a}$, $R_{3b}$ and capacitor $C_4$ operates as a mere bias circuit. When the supply voltage $+V_{CC}$ has become smaller than the Zener voltage $V_{ZD1}$ of the Zener diode $ZD_1$ of the bias circuit 5'', this Zener diode $ZD_1$ is cut off. While the Zener diode $ZD_1$ is in the cut-off state, the fluctuation of the supply voltage $+V_{CC}$ results in that of the reference voltage $V_{R2}$ substanially as it is. Accordingly, the forward voltages of the diodes $D_1$, $D_2$ change greatly, and the direct currents of the transistors $Q_9$, $Q_{14}$ of the initial-stage amplifier circuit 41 fluctuate greatly. Thus, the instability (noise, oscillation, etc.) of the amplifier circuit 4 arises. When the supply voltage $+V_{CC}$ has become higher than the Zener voltage

$V_{ZD1}$ of the Zener diode $ZD_1$ of the bisa circuit 5″ in Figure 7, this Zener diode $ZD_1$ turns "on". While the Zener diode $ZD_1$ is in the "on" state, the reference voltage $V_{R2}$ is hardly changed in spite of the fluctuation of the supply voltage $+V_{cc}$ and is maintained substantially constant by the Zener voltage $V_{ZD1}$. Accordingly, the forward voltages of the diodes $D_1$, $D_2$ are substantially stabilized, and also the direct currents of the transistors $Q_9$, $Q_{10}$ of the initial-stage amplifier circuit 41 are substantially stabilized. Thus, the amplifier circuit 4 operates stably.

Therefore, when the supply voltage $+V_{cc}$ repeats rise and fall with the boundary at the Zener voltage $V_{ZD1}$ of the Zener diode $ZD_1$ in a short time, the circuit operation of the amplifier in Figure 7 becomes very unstable.

In contrast, in the embodiment of Figure 6, the stability against the rise and fall of the supply voltage $+V_{cc}$ in a short time is enhanced for reason described below.

In the supply voltage detector 5′ of Figure 6, when the following condition is met in the case of the rise of the supply voltage $+V_{cc}$, the transistor $Q_1$ turns from the "on" state into the "off" state and the transistor $Q_2$ from the "off" state into the "on" state as in the embodiment of Figure 2:

$$V_{cc}>V_{ccx}=V_{ZD1}+\frac{R_1+_2}{R_1}\cdot V_{BEQ2} \qquad (8)$$

In the case of the rise of the supply voltage $+V_{cc}$, accordingly, the transistor $Q_1$ turns "on", the transistor $Q_2$ "off", the transistor $Q_3$ "on" and the transistor $Q_4$ "off" for $V_{cc}<V_{ccx}$, so that the direct current of the constant current load transistor $Q_{14}$ of the driving amplifier circuit 42 becomes null to stop the amplifying operation of the amplifier circuit 4.

On the other hand, when $V_{cc}>V_{ccc}$ has been met upon further rise in the supply voltage $+V_{cc}$, the transistor $Q_1$ turns "off", the transistor $Q_2$ "on" and the transistor $Q_3$ "off", so that the direct currents to flow through the collector-emitter paths of the transistors $Q_4$ and $Q_{15}$ are set by the direct current which flows through the resistor $R_9$ and the collector-emitter path of the transistor $Q_{16}$. Since the current proportional to the direct current of this transistor $Q_{15}$ begins to flow through the constant current load transistor $Q_{14}$, the driving amplifier circuit 42 and further the whole amplifier circuit 4 start the amplifying operations.

In addition, in the supply voltage detector 5′ of Figure 6, when the following condition has been met in the case of the fall of the supply voltage $+V_{cc}$, the transistor $Q_1$ turns from the "off" state into the "on" state and the transistor $Q_2$ from the "on" state into the "off" state as in the embodiment of Figure 2:

$$V_{cc}<V_{ccy}=V_{ZD1}+V_{BEQ2} \qquad (9)$$

In the case of the fall of the supply voltage $+V_{cc}$, accordingly, the transistor $Q_1$ is held in the "off" state, the transistor $Q_2$ in the "on" state and the transistor $Q_3$ in the "off" state for $V_{cc}>V_{ccy}$. The direct current therefore continues to flow through the constant current load transistor $Q_{14}$, so that the driving amplifier circuit 42 and further the whole amplifier circuit 4 continue the amplifying operations.

On the other hand, when $V_{cc}<V_{ccy}$ has been met upon further fall of the supply voltage $+V_{cc}$, the transistor $Q_1$ turns "on", the transistor $Q_2$ "off" and the transistor $Q_3$ "off". The direct current of the constant current load transistor $Q_{14}$ accordingly becomes null, so that the driving amplifier circuit 42 and further the whole amplifier circuit 4 stop the amplifying operations.

In this manner, the supply voltage detector 5 in Figure 2 and the supply voltage detector 5′ in Figure 6 have the hysteresis characteristics as stated above, which brings forth an advantage described hereunder. When the relationship between the resistance $R_1$ and $R_2$ is selected to be $R_2>R_1$, the first threshold voltage $V_{ccx}$ is set at a value sufficiently higher than the Zener voltage $V_{ZD1}$ as indicated by Expressions (4) and (8), while the second threshold voltage $V_{ccy}$ is set at a value somewhat higher than the Zener voltage $V_{ZD1}$ as indicated by Expressions (5) and (9). In the embodiments of Figures 2 and 6, when the supply voltage $+V_{cc}$ rises, the amplifying operation of the amplifier circuit 4 is started under the condition of $V_{cc}>V_{ccx}$ for the first time. The amplifying operation of the amplifier circuit 4 is not stopped even when, after the starting thereof, $V_{cc}<V_{ccx}$ has been established due to the fall of the supply voltage $+V_{cc}$, but is is stopped for the first time when $V_{cc}<V_{ccy}$ has been established due to the more fall of the supply voltage $+V_{cc}$. Accordingly, the disadvantage of the amplifier in Figure 7 (that is, the instability of the operation in the case of the rise and fall of the supply voltage $+V_{cc}$ with the boundary at the Zener voltage $V_{ZD1}$) is eliminated by the present invention.

The present invention thus far described can have various modifications within the scope of the fundamental technical idea thereof. The circuit arrangement of the amplifier circuit 4 (for example, the circuit arrangements of the initial-stage amplifier circuit 41, the driving amplifier circuit 42 and the push-pull output circuit 43) can be variously modified. The Zener diode $ZD_1$ can be replaced with another voltage regulator means (for example, a plurality of forward PN-junctions connected in series, a well-known constant voltage circuit utilizing the base-emitter forward voltage of a transistor, or the like).

Meanwhile, the voltage level of a car battery, which serves as the power source of an audio amplifier installed on an automobile, often fluctuates for a moment or over a long time during the starting operation of a car or at the ignition or wiper operation during the running.

Even in a general-purpose audio amplifier, when the on-off operations of a power switch are repeated, a supply voltage exhibits very abrupt changes.

It can be readily understood that the present invention demonstrates remarkable effects when utilized in these applications.

**Claims**

1. An amplifier comprising:
(a) an amplifier circuit (4) which amplifies an input signal (V in) while a supply voltage (+$V_{CC}$) is fed; and
(b) a supply voltage detector (5, 5') which detects magnitudes of the supply voltage (+$V_{CC}$), which starts an amplifying operation of said amplifier circuit (4) when the supply voltage (+$V_{CC}$) is raised and which stops the amplifying operation of said amplifier circuit (4) when the supply voltage (+$V_{CC}$) is low characterized in that said supply voltage detector (5, 5') has hysteresis characteristics as to a first threshold voltage ($V_{CCX}$) and a second threshold voltage ($V_{CCY}$) different from each other, said first threshold voltage ($V_{CCX}$) being set at a level higher than that of said second threshold voltage ($V_{CCY}$), that said supply voltage detector (5, 5') starts the amplifying operation of said amplifier circuit (4) when the supply voltage (+$V_{CC}$) has become higher in level than the first threshold voltage ($V_{CCX}$) during rise of the supply voltage (+$V_{CC}$), and that said supply voltage detector (5, 5') stops the amplifying operation of said amplifier circuit (4) when the supply voltage (+$V_{CC}$) has become lower in level than the second threshold voltage ($V_{CCY}$) during fall of the supply voltage (+$V_{CC}$).

2. An amplifier according to claim 1, wherein said supply voltage detector (5, 5') includes voltage regulator means ($ZD_1$), a constant voltage of which is utilized as a stabilized operating voltage ($V_{R2}$) of said amplifier circuit (4) and is also utilized for setting the first threshold voltage ($V_{CCX}$) and the second threshold voltage ($V_{CCY}$).

3. An amplifier according to claim 2, wherein both the first threshold voltage ($V_{CCY}$) and the second threshold voltage ($V_{CCX}$) are set at levels higher than the constant voltage ($V_{ZD1}$) of said voltage regulator means ($ZD_1$).

4. An amplifier according to claim 3, further comprising a smoothing circuit ($L_1$, $C_1$) through which the supply voltage (+$V_{CC}$) is fed to said amplifier circuit (4).

5. An amplifier according to claim 4, further comprising a speaker load (3) which is driven by an output signal of said amplifier circuit (4).

**Patentansprüche**

1. Verstärker mit
(a) einem Verstärkerkreis (4), der ein Eingangssignal ($V_{in}$) verstärkt, während eine Speisespannung (+$V_{CC}$) zugeführt wird; und
(b) einem Speisespannungsdetektor (5, 5'), der Größen der Speisespannung (+$V_{CC}$) erfaßt, einen Verstärkerbetrieb des Verstärkerkreises (4) bei hoher Speisespannung (+$V_{CC}$) auslöst und den Verstärkerbetrieb des Verstärkerkreises (4) bei niedriger Speisespannung (+$V_{CC}$) unterbricht, dadurch gekennzeichnet, daß der Speisespannungsdetektor (5, 5') ein Hystereseverhalten in bezug auf eine erste Schwellenspannung ($V_{CCX}$) und eine davon verschiedene zweite Schwellenspannung ($V_{CCY}$) hat, wobei die erste Schwellenspannung ($V_{CCX}$) auf einen höheren Pegel als die zweite Schwellenspannung ($V_{CCY}$) eingestellt ist, daß der Speisespannungsdetektor (5, 5') den Verstärkerbetrieb des Verstärkerkreises (4) auslöst, wenn bei ansteigender Speisespannung (+$V_{CC}$) der Pegel der Speisespannung (+$V_{CC}$) die erste Schwellenspannung ($V_{CCX}$) übersteigt, und daß der Speisespannungsdetektor (4) den Verstärkerbetrieb des Verstärkerkreises (4) unterbricht, wenn bei sinkender Speisespannung (+$V_{CC}$) der Pegel der Speisespannung (+$V_{CC}$) unter die zweite Schwellenspannung ($V_{CCY}$) gefallen ist.

2. Verstärker nach Anspruch 1, wobei der Speisespannungsdetektor (5, 5') einen Spannungsregler ($ZD_1$) aufweist, dessen Konstantspannung als stabilisierte Betriebsspannung ($V_{R2}$) des Verstärkerkreises (4) sowie ferner zur Einstellung der ersten Schwellenspannung ($V_{CCX}$) und der zweiten Schwellenspannung ($V_{CCY}$) genutzt wird.

3. Verstärker nach Anspruch 2, wobei sowohl die erste Schwellenspannung ($V_{CCX}$) als auch die zweite Schwellenspannung ($V_{CCY}$) auf über der Konstantspannung ($V_{ZD1}$) des Spannungsreglers ($ZD_1$) liegende Pegel eingestellt sind.

4. Verstärker nach Anspruch 3, ferner umfassend einen Glättungskreis ($L_1$, $C_1$), durch den die Speisespannung (+$V_{CC}$) dem Verstärkerkreis (4) zugeführt wird.

5. Verstärker nach Anspruch 4, ferner umfassend einen Verbraucher-Lautsprecher (3), der von einem Ausgangssignal des Verstärkerkreises (4) angesteuert wird.

**Revendications**

1. Amplifacteur comportant:
(a) un circuit amplificateur (4), qui amplifie un signal d'entrée (V in) tandis qu'une tension d'alimentation (+$V_{CC}$) est appliquée; et
(b) un détecteur (5, 5') de la tension d'alimentation, qui détecte les amplitudes de la tension d'alimentation (+$V_{CC}$), fait démarrer un opération d'amplification dudit circuit amplificateur (4) lorsque la tension d'alimentation (+$V_{CC}$) est accrue et arrête l'opération d'amplification dudit circuit amplificateur (4) lorsque la tension d'alimentation (+$V_{CC}$) est faible, caractérisé en ce que ledit détecteur (5, 5') de la tension d'alimentation possède une caractéristique d'hystérésis en ce qui concerne un première tension de seuil ($V_{CCX}$) et une seconde tension de seuil ($V_{CCY}$), qui sont différentes l'une de l'autre, ladite première tension de seuil ($V_{CCX}$) étant réglée à un niveau supérieur à celui de ladite seconde tension de seuil ($V_{CCY}$), que ledit détecteur (5, 5') de la tension d'alimentation déclenche l'opération d'amplification dudit circuit amplificateur (4) lorsque le niveau de la tension d'alimentation ($+V_{cc}$) est devenu supérieur à celui de la première tension de seuil ($V_{ccx}$) pendant la montée de la tension d'alimentation ($+V_{cc}$), et que ledit détecteur (5, 5') de la tension d'alimentation arrête l'opération d'amplification dudit circuit amplificateur (4) lorsque le niveau de la tension d'alimentation ($+V_{cc}$) est devenu inférieur à celui de la seconde tension de seuil ($V_{ccy}$) pendant la chute de la tension d'alimentation ($+V_{cc}$).

2. Amplificateur selon la revendication 1, dans lequel ledit détecteur (5, 5') de la tension d'alimentation comprend des moyens formant régulateur de tension ($ZD_1$), dont une tension constante est utilisée en tant que tension de fonctionnement stabilisée ($V_{R2}$) dudit circuit amplificateur (4) et est également utilisée pour régler la première tension de seuil ($V_{ccx}$) et la seconde tension de seuil ($VCC_y$).

3. Amplificateur selon la revendication 2, dans lequel à la fois la première tension de seuil ($V_{ccx}$) et la seconde tension de seuil ($VCC_y$) sont réglées à des niveaux supérieurs à la tension constante ($V_{ZD1}$) desdits moyens formant régulateur de tension ($ZD_1$).

4. Amplificateur selon la revendication 3, comportant en outre un circuit de lissage ($L_1$, $C_1$), par l'intermédiaire duquel la tension d'alimentation ($+V_{cc}$) est envoyée audit circuit amplificateur (4).

5. Amplificateur selon la revendication 4, comportant en outre une charge de haut-parleur (3) qui est commandée par un signal de sortie dudit circuit amplificateur (4).

## FIG. 1

## FIG. 2

## FIG. 3

## FIG. 4

## FIG. 5

*FIG. 6*

*FIG. 7*

0 106 953